# EUROPÄISCHE PATENTSCHRIFT

(11) **EP 1 008 144 B1**
(45) Veröffentlichungstag und Bekanntmachung des Hinweises auf die Patenterteilung: **03.04.2002**
(21) Anmeldenummer: 98947347.5
(22) Anmeldetag: 27.07.1998
(51) Int. Cl.: G11C 5/14, G06F 1/28, G06F 11/00

(54) **VERFAHREN ZUR ÜBERWACHUNG DER ORDNUNGSGEMÄSSEN FUNKTION EINER INTEGRIERTEN SCHALTUNG**
METHOD FOR MONITORING THE OPERATING CONDITION OF AN INTEGRATED CIRCUIT
PROCEDE POUR SURVEILLER LE FONCTIONNEMENT D'UN CIRCUIT INTEGRE

(30) Priorität: 20.08.1997 DE 19736195
(43) Veröffentlichungstag der Anmeldung: 14.06.2000
(73) Patentinhaber: Infineon Technologies AG, 81669 München (DE)
(72) Erfinder: KERN, Thomas, D-85579 Neubiberg (DE); SOMMER, Diether, D-80469 München (DE)
(74) Vertreter: Repkow, Ines, Dr. Dipl.-Ing.
(86) Internationale Anmeldenummer: DE9802115
(87) Internationale Veröffentlichungsnummer: WO9909558

(56) Entgegenhaltungen:
- EP-A- 0 598 475
- EP-A- 0 661 713
- WO-A-92/17886
- US-A- 5 199 032
- US-A- 5 371 709
- US-A- 5 397 946

## Beschreibung

Die vorliegende Erfindung betrifft ein Verfahren gemäß dem Oberbegriff des Patentanspruchs 1, d.h. ein Verfahren zur Überwachung der ordnungsgemäßen Funktion einer integrierten Schaltung, wobei die Versorgungsspannung der integrierten Schaltung überwacht wird und dabei festgestellte Einbrüche der Versorgungsspannung signalisiert werden.

Die ordnungsgemäße Funktion von Einrichtungen jeder Art ist verständlicherweise das angestrebte Ziel einer jeden Entwicklung. Dies gilt insbesondere für integrierte Schaltungen, denn dort können kleinste Fehler verheerende Auswirkungen haben. Man ist deshalb ständig bemüht, die Zuverlässigkeit integrierter Schaltungen zu erhöhen, was jedoch aufgrund der zunehmenden Größe von integrierten Schaltungen und deren Packungsdichte nicht gerade einfach ist.

Trotz aller bisherigen Bemühungen ist es bislang nicht gelungen, integrierte Schaltungen völlig fehlerfrei herzustellen und zu betreiben.

Ein Verfahren gemäß dem Oberbegriff des Patentanspruchs 1 ist in der dem US-Patent US 5,371,709 beschrieben. Dort erfolgt die Reaktion auf einen Versorgungsspannungseinbruch sofort, d. h. ohne Verzögerung. Das bedeutet jedoch auch, daß hier auch auf kurzfristige Einbrüche der Versorgungsspannung, die häufig gar keine Fehlfunktion der integrierten Schaltung zur Folge haben, durch eine Unterbrechung reagiert wird.

Weitere Verfahren zur Überwachung der ordnungsgemäßen Funktion von integrierten Schaltungen sind in der US 5,199,032, der US 5,397,946 sowie der EP 0 598 475 A2 beschrieben.

Der vorliegenden Erfindung liegt daher die Aufgabe zugrunde, das Verfahren gemäß dem Oberbegriff des Patentanspruchs 1 derart weiterzubilden, daß die Zuverlässigkeit von integrierten Schaltungen weiter verbessert wird.

Diese Aufgabe wird erfindungsgemäß durch ein Verfahren mit den Merkmalen des Patentanspruchs 1 gelöst.

Bei einem gattungsgemäßen Verfahren ist demnach vorgesehen, daß die Signalisierung erst erfolgt, wenn die Versorgungsspannung eine vorbestimmte Spannung für eine vorbestimmte Mindestdauer unterschreitet.

Die Signalisierung von Versorgungsspannungseinbrüchen ermöglicht es, die integrierte Schaltung bei Bedarf automatisch durch eine Überwachungsschaltung oder durch sich selbst oder manuell durch eine Bedienperson zur selektiven Wiederholung von Operationen, die während und/oder vor und/oder nach einem Versorgungsspannungseinbruch durchgeführt wurden und folglich möglicherweise nicht fehlerfrei abliefen, zu veranlassen; durch Versorgungsspannungseinbrüche verursachte Störungen sind dadurch sofort und nach außen hin zum Teil völlig unbemerkt wirkungsmäßig eliminierbar.

Es wurde mithin ein Verfahren zur Überwachung der ordnungsgemäßen Funktion einer integrierten Schaltung gefunden, durch welches die integrierte Schaltung nochmals erheblich zuverlässiger als bisher betrieben werden kann, wobei die Ursache für die erkannte Störung sowohl innerhalb als auch außerhalb der zu überwachenden integrierten Schaltung liegen kann.

Vorteilhafte Weiterbildungen der Erfindung sind Gegenstand der Unteransprüche.

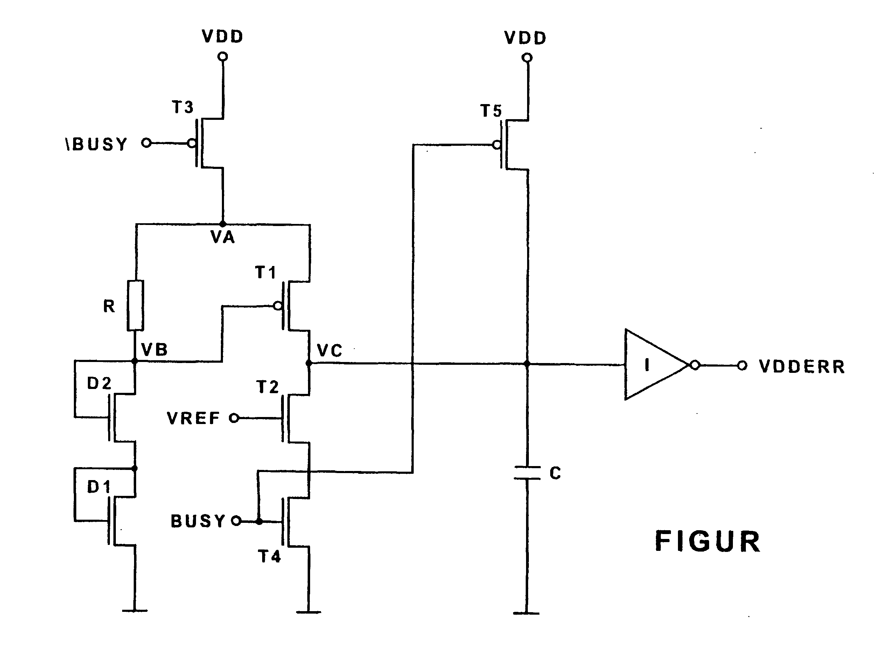

Die Erfindung wird nachfolgend anhand eines Ausführungsbeispiels unter Bezugnahme auf die Zeichnung näher beschrieben.

Die Figur zeigt eine Schaltung zur Durchführung des erfindungsgemäßen Verfahrens.

Die integrierte Schaltung oder der Teil der integrierten Schaltung, deren bzw. dessen ordnungsgemäße Funktion es zu überwachen gilt, ist im betrachteten Beispiel ein EEPROM. Allerdings besteht hierauf keine Einschränkung; die Erfindung ist auch in oder für beliebige andere integrierte Schaltungen oder Schaltungsteile einsetzbar.

Durch das beschriebene Verfahren wird die Versorgungsspannung der zu überwachenden integrierten Schaltung überwacht. Wird bei dieser Überwachung ein Versorgungsspannungseinbruch festgestellt, so wird dies der zu überwachenden integrierten Schaltung und/oder sonstigen Einrichtungen und/oder einer Bedienperson signalisiert, wobei unter den "sonstigen Einrichtungen" insbesondere solche Einrichtungen zu verstehen sind, durch welche die zu überwachende integrierte Schaltung angesteuert wird oder welche der zu überwachenden integrierten Schaltung nachgeordnet ist. Der Empfänger der Signalisierung kann dadurch erkennen, daß im Betrieb der integrierten Schaltung möglicherweise ein Fehler aufgetreten ist und wird somit in die Lage versetzt, gezielt Maßnahmen zu ergreifen, durch welche gegebenenfalls eingetretene Auswirkungen des erkannten Versorgungsspannungseinbruchs beseitigt oder gering gehalten werden können.

Wenn es sich bei der zu überwachenden integrierten Schaltung um ein EEPROM handelt, kann dadurch verhindert werden, daß die integrierte Schaltung unerkannt nicht richtig oder vollständig gelöscht oder programmiert wurde. Das Programmieren und Löschen von EEPROMs ist nämlich außerordentlich stark von der Versorgungsspannung abhängig, denn diese wird dort unter anderem auch als Referenzspannung für den Betrieb der Spannungspumpen zur Hochspannungserzeugung verwendet. Bricht die Versorgungsspannung ein, so reicht die erzeugte Hochspannung nicht mehr zum Programmieren und Löschen des EEPROM. Indem die Versorgungsspannung vorliegend jedoch überwacht wird und Versorgungsspannungseinbrüche signalisiert werden, kann ein während des Spannungseinbruches durchgeführter Programmier- und/oder Löschvorgang bei Bedarf wiederholt werden.

Eine Schaltung, durch welche die Überwachung der Versorgungsspannung und das Signalisieren von detektierten Versorgungsspannungseinbrüchen durchführbar ist, ist in der Figur veranschaulicht.

Die wie gezeigt oder auch anders aufgebaute Schaltung ist Bestandteil der zu überwachenden integrierten Schaltung selbst oder außerhalb derselben vorgesehen. Die Integration der Überwachungsschaltung in die zu überwachende integrierte Schaltung ist besonders vorteilhaft, denn dann können auch ausschließlich lokal innerhalb der zu überwachenden integrierten Schaltung auftretende Versorgungspannungseinbrüche detektiert werden.

Die in der Figur gezeigte Schaltung ist zur Realisierung als integrierte Schaltung oder Teil einer solchen ausgelegt. Sie umfaßt PMOS-Transistoren T1, T3 und T5, NMOS-Transistoren T2 und T4, (MOS-)Dioden D1 und D2, einen Inverter I, einen Widerstand R und einen Kondensator C, welche wie in der Figur gezeigt verschaltet sind.

Die Schaltung umfaßt mit VA, VB und VB bezeichnete Knotenpunkte, wobei sich
- der Knotenpunkt VA am Drain-Anschluß des Transistors T3,
- der Knotenpunkt VB am Gate-Anschluß des Transistors T1, und
- der Knotenpunkt VC zwischen den Transistoren T1 und T2 befindet.

In die Schaltung werden Eingangssignale VDD, VREF, BUSY und \BUSY eingegeben und ein Ausgangssignal VDDERR ausgegeben, wobei
- VDD die zu überwachende Versorgungsspannung ist und an die Source-Anschlüsse der Transistoren T3 und T5 angelegt wird,
- VREF eine Referenzspannung ist und an den Gate-Anschluß des Transistors T2 angelegt wird,
- BUSY ein Aktivierungssignal ist und an die Gate-Anschlüsse der Transistoren T4 und T5 angelegt wird,
- \BUSY das invertierte Aktivierungssignal BUSY ist und an den Gate-Anschluß des Transistors T3 angelegt wird, und
- das Ausgangssignal VDDERR das Signalisierungssignal zur Signalisierung erfaßter Versorgungsspannungseinbrüche ist und vom Inverter I ausgegeben wird.

Die eigentliche Versorgungsspannungsüberwachung erfolgt durch die Transistoren T1 und T2, von welchen der Transistor T2 eine aktive NMOS-Last bildet, welche durch die Referenzspannung VREF konstant angesteuert wird und somit als Stromsenke arbeitet. Die Transistoren T1 und T2 wirken so zusammen, daß sich an dem zwischen diesen liegenden Knotenpunkt VC
- ein von der Höhe der Versorgungsspannung VDD,
- dem sich am Knotenpunkt VB einstellenden Potential (Summe der Einsatzspannungen der Dioden D1 und D2), und
- dem W/L- Verhältnis der Transistoren T1 und T2 abhängendes Potential einstellt.

Die Schaltung wird über das Aktivierungssignal BUSY aktiviert. Dadurch werden die Transistoren T3 und T4 in den leitenden Zustand und der (Pullup-)Transistor T5 in den sperrenden Zustand versetzt.

Der leitende Zustand des Transistors T3 hat zur Folge daß das Potential am Knotenpunkt VA gleich VDD wird. Wenn und so lange die Versorgungsspannung VDD bestimmungsgemäß hoch ist, ist der Transistor T1 so niederohmig, daß sich am Knotenpunkt VC ein Potential einstellt, welches so hoch ist, daß das Ausgangssignal des nachgeschalteten Inverters I, welches zugleich das Ausgangssignal VDDERR der gesamten Schaltung repräsentiert, Null ist.

Wenn und so lange die Versorgungsspannung VDD und damit auch das Potential am Knotenpunkt VA einbricht, wird der Transistor T1 hochohmiger. Bei einem ausreichend weiten Einbrechen der Versorgungsspannung VDD wird der Transistor T1 so hochohmig, daß VC über die Transistoren T2 und T4 entladen wird. Wenn VC so weit entladen ist, daß der Kippunkt des nachgeschalteten Inverters I erreicht wird, so wird dessen Ausgangssignal gleich VDD.

Durch den Kondensator C wird erreicht, daß der Inverter I nur auf Versorgungsspannungseinbrüche mit einer bestimmten Mindestdauer (beispielsweise einige 10 ns) reagiert.

Das Ausgangssignal VDDERR der Schaltung ist Null, wenn und so lange die Versorgungsspannung VDD in etwa ihren Sollwert innehat. Sinkt die Versorgungsspannung VDD unter einen vorbestimmten Wert ab, so wechselt VDDERR eine vorbestimmte Zeit nach dem Unterschreiten des vorbestimmten Wertes auf VDD (sofern die Versorgungsspannung VDD nicht zwischenzeitlich wieder die vorbestimmte Spannung erreicht oder überstiegen hat). VDDERR bleibt auf VDD-Potential, bis VDD die vorbestimmte Spannung wieder erreicht hat oder übersteigt.

Das Ausgangssignal VDDERR signalisiert mithin die Höhe der Versorgungsspannung VDD. Solange VDDERR gleich Null ist, hat die Versorgungsspannung VDD in etwa ihren Sollwert inne und es kann davon ausgegangen werden, daß die zu überwachende integrierte Schaltung ordnungsgemäß arbeitet. Ein sprunghaftes Ansteigen von VDDERR ist ein Anzeichen dafür, daß VDD für eine bestimmte Mindestdauer eingebrochen ist, wodurch die zu überwachende integrierte Schaltung möglicherweise vorübergehend nicht ordnungsgemäß gearbeitet hat. Ein solcher Anstieg wird im betrachteten Beispiel optisch und/oder akustisch angezeigt (um die Bedienperson zur Vornahme geeigneter Maßnahmen anzuregen) oder von der zu überwachenden integrierten Schaltung oder einer sonstigen Einrichtung zur automatischen Veranlassung einer Wiederholung oder Nichtberücksichtigung der während der Dauer der Störung ausgeführten Operationen verwendet. Die automatische oder manuelle Veranlassung der Wiederholung bestimmter Operationen erfolgt zweckmäßigerweise erst dann, wenn die Versorgungsspannung wieder ungestört (VDDERR gleich Null) ist.

Die beschriebene Versorgungsspannungsüberwachung wird nur durchgeführt, wenn und so lange das Aktivierungssignal BUSY an die Überwachungsschaltung angelegt wird. Ist das Aktivierungssignal BUSY nicht angelegt, so sorgt der Transistor T5 dafür, daß das Ausgangssignal VDDERR der Überwachungsschaltung dauerhaft auf Null liegt, wodurch ein ordnungsgemäßer Betrieb der integrierten Schaltung signalisiert wird.

Auf die beschriebene Art und Weise kann erreicht werden, daß die überwachte integrierte Schaltung erheblich zuverlässiger betrieben werden kann als es bisher der Fall war.

## Patentansprüche

1. Verfahren zur Überwachung der ordnungsgemäßen Funktion einer integrierten Schaltung, wobei die Versorgungsspannung (VDD) der integrierten Schaltung überwacht wird und dabei festgestellte Einbrüche der Versorgungsspannung signalisiert werden,
**dadurch gekennzeichnet,**
**daß** die Signalisierung erst erfolgt, wenn die Versorgungsspannung (VDD) eine vorbestimmte Spannung für eine vorbestimmte Mindestdauer unterschreitet.

2. Verfahren nach Anspruch 1,
**dadurch gekennzeichnet,**
**daß** die Signalisierung eines Versorgungsspannungseinbruchs durch die Ausgabe eines etwa Null Volt aufweisenden Signalisierungssignals (VDDERR) erfolgt.

3. Verfahren nach Anspruch 2,
**dadurch gekennzeichnet,**
**daß** das Signalisierungssignal (VDDERR) den Wert der Versorgungsspannung (VDD) annimmt, wenn und so lange kein ausreichend weiter und langer Einbruch der Versorgungsspannung vorliegt.

4. Verfahren nach einem der vorhergehenden Ansprüche,
**dadurch gekennzeichnet,**
**daß** die Überwachung nur durchgeführt wird, wenn und so lange an die Überwachungsschaltung ein Aktivierungssignal (BUSY) angelegt wird.

5. Verfahren nach Anspruch 4,
**dadurch gekennzeichnet,**
**daß** bei nicht angelegtem Aktivierungssignal (BUSY) das Signalisierungssignal (VDDERR) ausgegeben wird, das bei aktivierter Überwachung ausgegeben würde, wenn und so lange die Versorgungsspannung (VDD) ordnungsgemäß hoch ist.

6. Verfahren nach einem der vorhergehenden Ansprüche,
**dadurch gekennzeichnet,**
**daß** die Überprüfung der Höhe der Versorgungsspannung (VDD) unter Verwendung einer von der Höhe der Versorgungsspannung unabhängigen Referenzspannung (VREF) durchgeführt wird.

7. , Verfahren nach einem der vorhergehenden Ansprüche,
**dadurch gekennzeichnet,**
**daß** die Überwachungsschaltung innerhalb der zu überwachenden integrierten Schaltung vorgesehen wird.

8. Verfahren nach einem der vorhergehenden Ansprüche,
**dadurch gekennzeichnet,**
**daß** das Erfassen eines Einbruchs der Versorgungsspannung zum Anlaß genommen wird, diejenigen Operationen, die durch den Versorgungsspannungseinbruch beeinflußt worden sind und/oder sein können, nach dem Ende des Versorgungsspannungseinbruchs zu wiederholen.

## Claims

1. A method for monitoring the proper functioning of an integrated circuit, the supply voltage (VDD) of the integrated circuit being monitored and dips in the supply voltage that are ascertained in the process being signaled,
**characterized**
**in that** the signaling is only effected if the supply voltage (VDD) falls below a predetermined voltage for a predetermined minimum duration.

2. The method as claimed in claim 1,
**characterized**
**in that** the signaling of a supply voltage dip is effected by the outputting of a signaling signal (VDDERR) having approximately zero volts.

3. The method as claimed in claim 2,
**characterized**
**in that** the signaling signal (VDDERR) assumes the value of the supply voltage (VDD) if and as long as a sufficiently wide and long dip in the supply voltage is not present.

4. The method as claimed in one of the preceding claims,
**characterized**
**in that** the monitoring is carried out only if and as long as an activation signal (BUSY) is applied to the monitoring circuit.

5. The method as claimed in claim 4,
**characterized**
**in that** if an activation signal (BUSY) is not applied, the signaling signal (VDDERR) is output which would be output in the event of activated monitoring if and as long as the supply voltage (VDD) is properly high.

6. The method as claimed in one of the preceding claims,
**characterized**
**in that** the checking of the level of the supply voltage (VDD) is carried out using a reference voltage (VREF) which is independent of the level of the supply voltage.

7. The method as claimed in one of the preceding claims,
**characterized**
**in that** the monitoring circuit is provided within the integrated circuit to be monitored.

8. The method as claimed in one of the preceding claims,
**characterized**
**in that** the detection of a dip in the supply voltage is taken as a reason to repeat those operations which have been and/or may be influenced by the supply voltage dip after the end of the supply voltage dip.

## Revendications

1. Procédé de surveillance du bon fonctionnement d'un circuit intégré, la tension d'alimentation (VDD) du circuit intégré étant surveillée et les chutes ainsi détectées de la tension d'alimentation étant signalées, **caractérisé en ce que** la signalisation n'a lieu que lorsque la tension d'alimentation (VDD) devient inférieure à une tension prédéfinie pendant une durée minimale donnée.

2. Procédé selon la revendication 1, **caractérisé en ce que** la signalisation d'une chute de la tension d'alimentation est réalisée en délivrant un signal de signalisation (VDDERR) d'environ zéro volt.

3. Procédé selon la revendication 2, **caractérisé en ce que** le signal de signalisation (VDDERR) prend la valeur de la tension d'alimentation (VDD) lorsque et tant qu'il n'existe pas de chute suffisamment importante et longue de la tension d'alimentation.

4. Procédé selon l'une des revendications précédentes, **caractérisé en ce que** la surveillance n'est effectuée que si et tant qu'un signal d'activation (BUSY) est appliqué au circuit de surveillance.

5. Procédé selon la revendication 4, **caractérisé en ce que** lorsque le signal d'activation (BUSY) n'est pas appliqué, le signal de signalisation (VDDERR) émis est celui qui serait émis si et tant que la tension d'alimentation (VDD) avait le niveau correct si la surveillance était activée.

6. Procédé selon l'une des revendications précédentes, **caractérisé en ce que** le contrôle du niveau de la tension d'alimentation (VDD) est réalisé en utilisant une tension de référence (VREF) indépendante du niveau de la tension d'alimentation.

7. Procédé selon l'une des revendications précédentes, **caractérisé en ce que** le circuit de surveillance est prévu à l'intérieur du circuit intégré à surveiller.

8. Procédé selon l'une des revendications précédentes, **caractérisé en ce que** la détection d'une chute de la tension d'alimentation est prise comme motif pour répéter après la fin de la chute de la tension d'alimentation les opérations qui ont été et/ou auraient pu être influencées par la chute de la tension d'alimentation.
